# EUROPEAN PATENT APPLICATION

(11) **EP 2 555 083 A1**
(43) Date of publication of application: **06.02.2013**
(21) Application number: 11176099.7
(22) Date of filing: 01.08.2011
(51) Int. Cl.: G06F 1/26, G06F 3/033, G06F 3/038

(54) **Mouse charging system**

(71) Applicant: Giga-Byte Technology Co., Ltd., Hsin Tien 231, Taipei County (TW)
(72) Inventor: Lin, Yin Yu, 231 Hsin Tien (TW)
(74) Representative: Schwerbrock, Florian

(57) **Abstract**

A mouse charging device is applying to an electronic device which comprises a power supply and a first connecting port. The mouse charging device comprises a mouse and a receiver. A charging module of the mouse is disposed in a shell of the mouse, and a first conductive piece of the mouse is disposed on the shell. The first conductive piece is electrically connected to the charging module. The receiver comprises a second connecting port and a second conductive piece. The second connecting port is electrically plugged in the first connecting port and electrically connected to the power supply. The second conductive piece is selectively coupled to the first conductive piece of the mouse. As the second conductive piece and the first conductive piece are coupled together, the power supply of the electronic device is available to charge the charging module of the mouse.

## Description

### BACKGROUND OF THE INVENTION

### Field of the Invention

The present invention relates to a charging system and more particularly relates to a charging system, where the charge of a wireless mouse is by means of electrically coupling of conductive pieces.

### Description of the Prior Art

At present, the majority of wireless mice on the market won't work under the conditions of low voltage or no power at all. And the ways to energize the wireless mouse comprise: displacing a new battery to the wireless mouse, connecting electrically the wireless mouse with an electronic device by universal serial bus (USB), or plugging the wireless mouse into a charger, and the above various charging ways enable the wireless mouse to keep in use.

Although the forgoing ways of replacing a new battery to the wireless mouse and plugging the wireless mouse to a charger for charging the wireless mouse can keep the wireless mouse to continuously operate, however, in a long time use, the wireless mouse still suffers situations as low voltage and even no power. A description is given for the problem of replacing batteries: the battery, which can not be reused for long, will cause environmental and mercury pollution problems to the earth.

Although the way of charging the wireless mouse by a charger improves the problems of replacing the battery and solves the technical problems of power in the wireless mouse and the problems of the environmental protection; however, the charger of any shape or size will always occupy space. Furthermore, the charger needs wires for electrically connecting, and the production brings about cost of material. Moreover, repeated use will also destroy the charger.

The way of electrical connection of the wireless mouse with an electronic device by USB is similar to that of a wired mouse. The only difference is that the wireless mouse is a real cordless type once the USB line is removed after the wireless mouse is fully charged.

However, a user shall prepare the wires or the charger by himself (or herself) when the charging is by wires or the charger. Sometimes the user tends to forget to take along the wires or the charger, which would fail to charge the wireless mouse so that the wireless mouse is incapable of being used.

### SUMMARY OF THE INVENTION

In view of the forgoing problems, the present invention provides a mouse charging system for solving multiple problems, comprising environment, economic benefit and use space, relating to the frequent replacement of battery for the traditional wireless mouse or the required carrying of the connecting wires and chargers.

The present invention discloses a mouse charging system, applying to an electronic device which comprises a power supply and a first connecting port. The mouse charging system comprises a mouse and a receiver. The mouse comprises a shell, a charging module which is disposed in the shell, and a first conductive piece which is disposed on the shell, and the first conductive piece is electrically connected to the charging module.

The receiver comprises a second connecting port and a second conductive piece. The second connecting port is disposed on one end of the receiver, and the second connecting port is electrically plugging in the first connecting port of the electronic device, resulting in the electrical connection between the second connecting port and the power supply of the electronic device. The second conductive piece is disposed on another end of the receiver, and the second conductive piece is selectively coupled to the first conductive piece of the mouse. As the second conductive piece of the receiver and the first conductive piece of the mouse are coupled together, the electrical energy provided by the power supply of the electronic device can be transferred to charge the charging module of the mouse by means of the conduction between the first conductive piece of the mouse and second conductive piece of the receiver.

The effectiveness of the present invention lies in how the power supply of the electronic device charges the charging module of the mouse of the wireless mouse. As the second connecting port of the receiver is plugging in the first connecting port of the electronic device during the situation that the wireless mouse is in low voltage or no power state at all and the first conductive piece of the wireless mouse is attached directly to form electrical coupling with the second conductive piece of the receiver. Thus by means of the technique of the present invention, users are available to charge the wireless mouse without taking along any wires or chargers.

The characteristics, realization and functions of the present invention and disclosed in the following description with reference to the preferred exemplified embodiments and the accompanying drawings.

### BRIEF DESCRIPTION OF THE DRAWINGS

FIG. 1 is a three-dimensional diagram of a mouse charging system of one embodiment of the present invention;
FIG. 2 is a circuit block diagram of a mouse charging system of one embodiment of the present invention;
FIG. 3 is an exploded view of a mouse charging system of one embodiment of the present invention;
FIG. 4 is a three-dimensional schematic diagram of a charging status of the mouse of one embodiment of the present invention;
FIG. 5 is a plan view of a charging status of the mouse of one embodiment of the present invention; and
FIG. 6 is a plan view of a charging status of the mouse of another embodiment of the present invention.

### DETAILED DESCRIPTION OF THE INVENTION

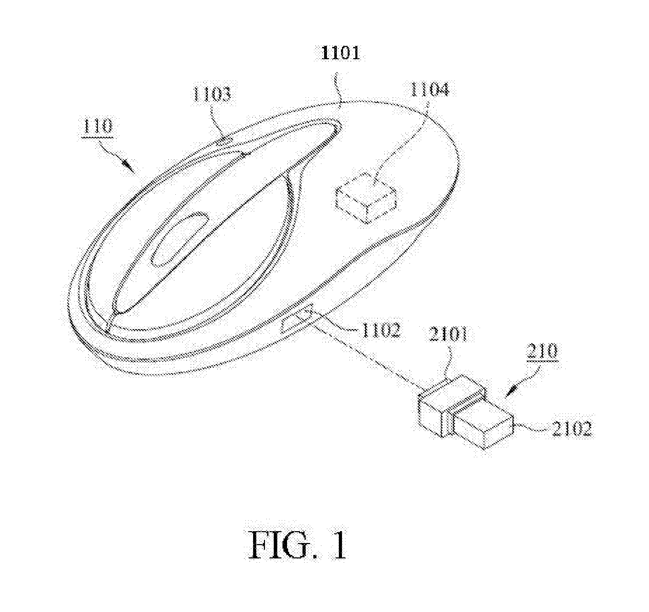

Referring to FIGS. 1 to 3, they show the three-dimensional diagrams and the circuit block diagram. The mouse charging system of an embodiment of the present invention, a mouse charging system is applying to an electronic device 310. The electronic device 310 comprises a power supply 3101 and a first connecting port 3102. The mouse charging system comprises a mouse 110 and a receiver 210.

In this embodiment, the mouse 110 and the receiver 210 transmit displacement control signal by wireless communication. That means the mouse 110 receives and transfers signals by the wireless connection through the receiver 210 to operate the cursor of the electronic device 310 for controlling the displacement of cursor to operate the electronic device 310. Controlling the displacement of the cursor in a windows of operation system of the electronic device by a wireless connection is a known technology, thus the applicant does not describe this known technology here.

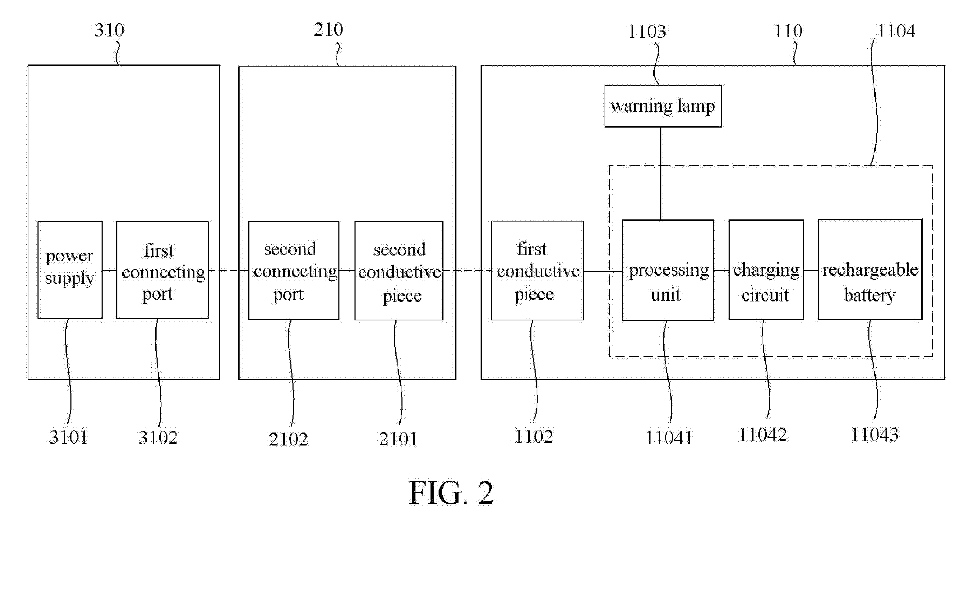

Referring to FIGS. 1 and 2, the mouse 110 comprises a shell 1101, a first conductive piece 1102, a warning lamp 1103 and a charging module 1104. The charging module 1104 is disposed in the mouse 110, and the first conductive piece 1102 is disposed on the shell 1101. The first conductive piece 1102 is electrically connected to the charging module 1104.

The charging module 1104 of the present invention comprises a processing unit 11041, a charging circuit 11042 and a rechargeable battery 11043. The processing unit 11041 is electrically connected to the first conductive piece 1102 and the warning lamp 1103 of the mouse 110. The charging circuit 11042 is electrically connected to the processing unit 11041. The rechargeable battery 11043 is electrically connected to the charging circuit 11042. Furthermore, the first conductive piece 1102 of the mouse 110 is powered by the power supply 3101 of the electronic device 310, and the power supply 3101 charges the rechargeable battery 11043 by routing through the processing unit 11041 and the charging circuit 11042.

Referring again to FIGS. 1 and 2, the receiver 210 of the present invention comprises a second conductive piece 2101 and a second connecting port 2102. The electronic device 310 comprises a power supply 3101 and a first connecting port 3102. The receiver 210 selectively takes the second connecting port 2102 to plug in the first connecting port 3102 of the electronic device 310, to connect electrically the receiver 210 and the power supply 3101 of the electronic device 310. In addition, another function of the receiver 210 is to receive the displacement path of the wireless mouse. However, this is a known technology which won't be described in this embodiment.

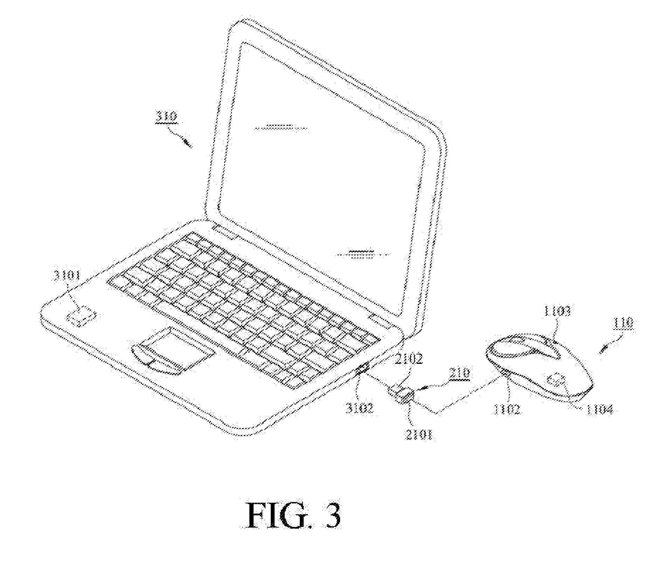

Please refer to FIG. 3, it shows an exploded view of the mouse charging system of the embodiment of the present invention. The first conductive piece 1102 and the second conductive piece 2101 of the embodiment disclosed in the present invention are magnetic conductive pieces. The first conductive piece 1102 and the second conductive pieces 2101 are coupled together by magnetic attraction. In this embodiment, the first conductive piece 1102 and the second conductive piece 2101 are made of iron, nickel, cobalt, ferrosilicon or any material that is used as a magnetic conductor. Moreover, the first conductive piece 1102 and the second conductive piece 2101 take circle, square, rectangle or any other shapes. It's worth to notice that the present invention does not limit the materials and shapes of the first conductive piece 1102 and the second conductive piece 2101. For a person skilled in the art could amend the materials and shapes of the first conductive piece 1102 and the second conductive piece 2101 depending on the practical designing requirements or using requirements.

Please refer to FIGS. 3 to 5, which show the exploded view and diagrams of the charging state. In one embodiment of the present invention, when a user uses the wireless mouse in a long time making the wireless mouse lose power, the processing unit 11041 of the mouse charging system detects the power state of the rechargeable battery 11043 and selectively signals the warning lamp 1103. Therefore, the warning lamp 1103 signals a warming for showing the user that the wireless mouse needs to charge.

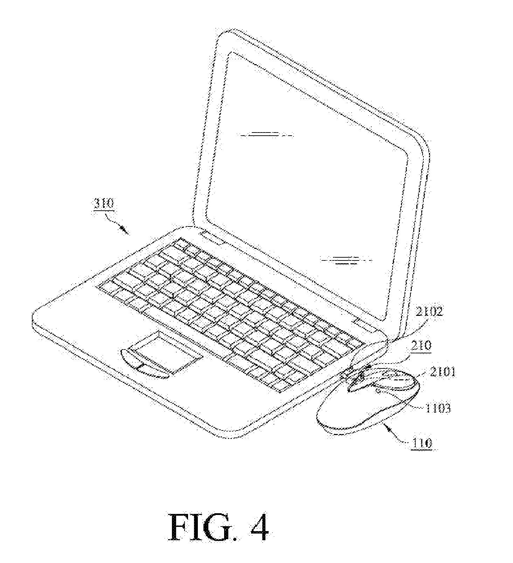

For example, please refer to FIGS. 3 and 4, and go with FIG. 2 at the same time, as the warning lamp 1103 of the mouse 110 signals a warming about low voltage or no power state, the user can take the second connecting port 2102 of the receiver 210 plugging to the first connecting port 3102 of the electronic device 310 at first. Thus, the receiver 210 is electrically connected to the power supply of the electronic device 310. Subsequently, the first conductive piece 1102 of the mouse 110 and the second conductive piece 2101 of the receiver 210 are coupled together by magnetic attraction. At this time, the electrical energy of the power supply 3101 of the electronic device 310 is from the first connecting port 3102 passing through the second connecting port 2102 and the second conductive piece 2101 of the receiver 210 into the first conductive piece 1102 of the mouse 110, then charges the rechargeable battery 11043 through the charging circuit 11042 and the processing unit 11041 in the charging module 1104 of the mouse 110. When the power reaches the fully charging state, the warning lamp 1103 of the mouse 110 will signal a warning about the fully charging state for the user. The user can separate the mouse 110 from the receiver 210 and continues to use the wireless mouse.

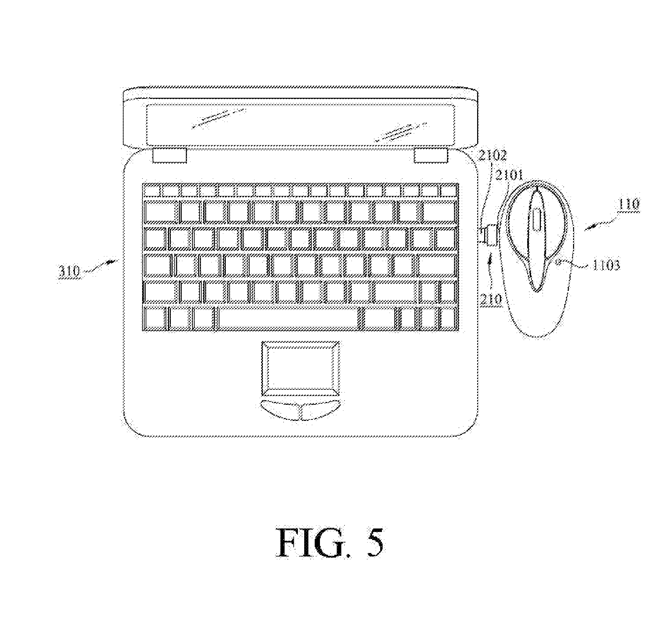

Please refer to FIG. 5, it shows a plan view of charging state of the mouse 110 of the present embodiment. FIG. 5 illustrates clearly that when the warning lamp 1103 signals a warning about low voltage or no power state, the receiver 210 is plugged into the electronic device 310 and the mouse 110 is electrically connected to the receiver 210 for charging. It's worth to notices that, in this embodiment, the warning lamp 1103 is triggered to radiate a light color, such as a red flasher, for signaling low voltage or no power state, and radiate another light color, such as a green continuing light, for signaling power fully charging state. However, the present invention does not limit the numbers or light colors of the warning lamps 100. A person skilled in the art could amend the numbers and color lights of the warning lamp 1103 depending on the practical designing requirements or using requirements.

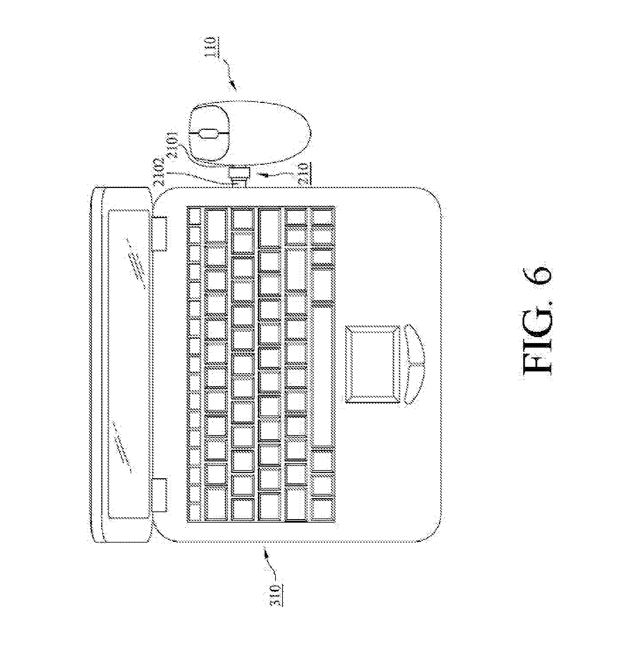

Please refer to FIG. 6, it shows a plan view of charging state of the mouse 110 of another embodiment of the present invention. In this embodiment, any warning lamp 1103 doesn't need to being disposed on the mouse 110. In general, a user needs to plug the receiver 210 into the electronic device 310 before he (or she) use the wireless mouse. He (or she) finds the displacements of the cursor in the windows slowly or non-response when he (or she) moves the wireless mouse, and this situation means that the mouse 110 of the wireless mouse in low voltage or no power state. Therefore, the user should keep the mouse 110 connect electrically to the receiver 210 for charging the mouse 110 through the receiver 210.

As mentioned-above, the mouse charging system technology disclosed in the present invention can make users without taking along any wires or chargers to charge their wireless mouse.

The present invention has been described with reference to the preferred embodiment thereof and it is understood that the embodiments are not intended to limit the scope of the present invention. Moreover, as the contents disclosed herein should be readily understood and can be implemented by a person skilled in the art, all equivalent changes or modifications which do not depart from the spirit of the present invention should be encompassed by the appended claims.

## Claims

1. A mouse charging system, applying to an electronic device, the electronic device comprising a power supply and a first connecting port, the mouse charging system comprising:
a mouse, comprising:
a shell;
a charging module, disposed in the shell; and
a first conductive piece, disposed on the shell, and the first conductive piece electrically connected to the charging module; and
a receiver, comprising:
a second connecting port, disposed on one end of said receiver, and the second connecting port electrically plugging in the first connecting port and electrically being connected to the power supply; and
a second conductive piece, disposed on another end of said receiver, and the second conductive piece selectively being coupled to the first conductive piece;
wherein, as the second conductive piece and the first conductive piece are coupled together, the power supply of the electronic device charges the charging module of said mouse through said receiver.

2. A mouse charging system as in claim 1, wherein the charging module further comprises:
a processing unit, electrically connected to the first conductive piece;
a charging circuit, electrically connected to the processing unit; and
a rechargeable battery, electrically connected to the charging circuit;
wherein said mouse is powered by the power supply of the electronic device, and the power supply charges the rechargeable battery by routing through the processing unit and the charging circuit.

3. A mouse charging system as in claim 2, further comprising a warming lamp electrically connected to the processing unit, and the processing unit selectively signals the warning lamp to trigger said warming lamp to signal a warming.

4. A mouse charging system as in claim 1, wherein the first conductive piece and the second conductive piece are magnetic conductive pieces, and the first conductive piece and the second conductive piece are coupled together by magnetic attraction.

5. A mouse charging system as in claim 4, wherein the first conductive piece and the second conductive piece are made of iron, nickel, cobalt, ferrosilicon or any material that is used as a magnetic conductor.

6. A mouse charging system as in claim 1, wherein the first conductive piece and the second conductive piece take circle, square, rectangle or any other shapes.

7. A mouse charging system as in claim 1, wherein said mouse communicates with the electronic device by a wireless connection.
